# EUROPEAN PATENT APPLICATION

(11) **EP 4 667 982 A1**
(43) Date of publication of application: **24.12.2025**
(21) Application number: 25180894.5
(22) Date of filing: 04.06.2025
(51) Int. Cl.: G02B 5/08, G03F 7/00

(54) **OPTICAL ELEMENT FOR REFLECTION OF RADIATION IN THE VUV WAVELENGTH REGION**

(30) Priority: 21.06.2024 DE 102024205788
(71) Applicant: Carl Zeiss SMT GmbH, 73447 Oberkochen (DE)
(72) Inventor: Lange, Felix, 73447 Oberkochen (DE); Pazidis, Alexandra, 73447 Oberkochen (DE); Forcht, Konstantin, 73447 Oberkochen (DE); Wiegand, Alexander, 73447 Oberkochen (DE); Schick, Katja, 73447 Oberkochen (DE); Haertling, Marcel, 73447 Oberkochen (DE)
(74) Representative: Kohler Schmid Möbus Patentanwälte

(57) **Abstract**

The invention relates to an optical element (1) for reflection of radiation (2) in the VUV wavelength region, comprising: a surface (4a, 4a'), and a dielectric multilayer coating (5) applied to the surface (4a, 4a'). The dielectric multilayer coating (5) is designed for reflection, in particular for broadband reflection, of radiation (2) in the VUV wavelength region. The surface (4a, 4a') is formed from a preferably metallic base material having a reflectivity of 60% or less in the VUV wavelength region, in particular of 50% or less. It is preferable that the base material for reflection of radiation (3) in the UV/VIS wavelength region has a reflectivity at at least one wavelength (λ_{VIS}) in the UV/VIS wavelength region of more than 50%, preferably of more than 70%, more preferably of more than 80%, in particular of more than 90%. The invention also relates to an optical assembly for the VUV wavelength region that comprises at least one such optical element (1).

## Description

### Cross-reference to related application

This application claims priority to German Patent Application No. 102024205788.6, filed June 21, 2024, the entire disclosure of which is considered part of and is incorporated by reference in the disclosure of this application.

### Background of the invention

The invention relates to an optical element for reflection of radiation in the VUV wavelength region, comprising: a surface, and a dielectric multilayer system applied to the surface. The invention also relates to an optical assembly for the VUV wavelength region, in particular a VUV lithography apparatus or a wafer inspection system, comprising: at least one optical element as described further up.

It is typically the case that reflective optical elements for the UV wavelength region, in particular for the VUV wavelength region, have a metallic surface, i.e. a surface which is formed from a metallic material, where it is the metallic material that makes the main contribution to the reflectivity of the optical element. It is possible for the metallic surface to be formed on a substrate of the reflective optical element consisting of the metallic material. It is also possible that the metallic surface is formed on a metallic layer applied to a substrate of the optical element, where the substrate itself need not necessarily consist of a metallic material.

Especially for reflection of radiation in the VUV wavelength region, i.e. between 100 nm and 200 nm (VUV wavelength region according to DIN 5031 Part 7), metallic layers consisting of aluminium are frequently used, since aluminium has the highest reflectivity in this wavelength range. In particular, a surface formed from aluminium enables high reflection of 90% over a broadband wavelength range of about 115 nm into the infrared wavelength region. However, aluminium has very low stability against environmental influences and UV radiation, and is prone to oxidation, which greatly reduces reflectivity. Because of the high tendency of aluminium to be oxidized, at least one protective layer is generally applied to a metallic layer in the form of an aluminium layer. The protective layer is typically a fluoride layer, in particular a metal fluoride layer, for example MgF₂ or AlF₂.

DE102018211499A1 describes a reflective optical element for the VUV wavelength region, which comprises a substrate and a metal layer. The optical element has at least one metal fluoride layer on the side of the metal layer that faces away from the substrate, and at least one oxide layer on the side thereof that faces away from the substrate. The electrical field of a stationary wave that forms on reflection should have a minimum in the region of the at least one oxide layer. The metal layer may be aluminium, an aluminium alloy, rhodium, ruthenium, palladium, osmium, iridium, platinum, magnesium or a combination thereof.

WO2006053705A1 describes a method of protecting a metal mirror against degradation and a dielectrically protected metal mirror for UV radiation having wavelengths between 120 nm and 260 nm. The metal mirror has a substrate, a mirror layer applied to the substrate and having a reflective metal layer, and a protective layer applied to the mirror layer, for example of chiolite, for protection against degradation of the reflection properties by environmental influences. The metal layer may consist essentially of a pure metal, in particular of aluminium, of a metal alloy or of a semimetal. A dielectric multilayer system may be applied to the protective layer.

It has been shown that, in operation of reflective optical elements for the VUV wavelength region that have an aluminium layer, in spite of the protective layer, atoms from the gas phase are transported very effectively to the surface of the aluminium layer. The protective layer has therefore been found to be effective only when the intensity of the incident radiation is low, as is the case with measuring instruments for example. If aluminium provided with a protective layer is to be used, for example, in exposure or inspection systems for wafers or masks at wavelengths below 190 nm, severe degradation is to be expected. Since aluminium is a very reactive metal, it forms an oxide on contact with oxygen and a fluoride on contact with fluorine. This can adversely affect the lifetime of the optical element, or the reflectivity of the optical element can be largely lost in this case in parts of the VUV wavelength region.

### Object of the invention

It is an object of the invention to provide an optical element for reflecting radiation in the VUV wavelength region that has low sensitivity to environmental influences, in particular with respect to reaction with fluorine. It is also an object of the invention to provide an optical assembly comprising such an optical element.

### Subject-matter of the invention

This object is achieved in a first aspect by an optical element of the type specified at the outset in which the dielectric multilayer coating is designed for reflection, in particular for broadband reflection, of radiation in the VUV wavelength region, and in which the surface is formed from a preferably metallic base material having a reflectivity of 60% or less in the VUV wavelength region, in particular of 50% or less. A reflectivity of 60% or 50% or less in the VUV wavelength region means that the base material does not have a reflectivity of more than 60% or 50% over any wavelength range of more than 30 nm in width in the VUV wavelength region. Reflectivity refers here to perpendicular incidence.

The inventors have recognized that an optical element for reflection of VUV radiation does not necessarily require a surface of a metallic base material that provides a majority of the reflectivity of the optical element for reflection in the VUV wavelength region. In fact, the (highly) reflective multilayer coating can also generate high reflectivity for the VUV radiation even if the base material itself has comparatively low reflectivity. In particular, it is not necessary for the surface with the base material to consist of aluminium.

Because of the fact that the base material of the surface has comparatively low reflectivity in the VUV wavelength region, it is possible to use materials other than aluminium, in particular materials that are more stable than aluminium with respect to reaction with fluorine (see below). In this way, it is possible to counteract degradation of the optical element and to save costs. The metallic base material of the surface is generally a pure metal, but it is also possible in principle that the metallic base material is a metal alloy or a semimetal. Alternatively, the base material of the surface may be a nonmetallic base material, e.g. a semiconductor or an insulator.

The dielectric multilayer coating enables achievement of high reflectivity with simultaneously good stability with respect to the ambient conditions, especially with respect to incident VUV radiation. The high reflectivity may only be achieved for one or more narrow wavelength ranges, since only a limited number of dielectrics are available. However, the dielectric multilayer coating may also be designed for broadband reflection of VUV radiation.

The dielectric multilayer coating may, for example, have reflectivity of more than 60% or more than 70%, preferably of more than 80% or 85%, in a wavelength range within the VUV wavelength region having a width of at least 20 nm, preferably of at least 30 nm, in particular of at least 60 nm, or having a total width as the sum of the part-ranges of at least 20 nm, preferably of at least 30 nm, more preferably of at least 60 nm. In combination with the reflectivity of the surface from the base material, the optical element may have a reflectivity in the VUV wavelength region of 60% or more, 70% or more, 80% or more, or 85% or more, over a wavelength range having a width or a sum of part-ranges having a total width of at least 20 nm, 30 nm or 60 nm.

For example, it is possible that the reflective optical element has a surface of a base material, e.g. a metallic material, that has a reflectivity of at least 30% in a wavelength range of at least 15 nm within the VUV wavelength region. Reflectivity in this wavelength range and/or in another wavelength range within the VUV wavelength region can be increased by the dielectric multilayer coating such that a reflectivity of the optical element of 60% or more, of 70% or more, of 80% or more or of 85% or more is achieved in wavelength ranges totalling at least 20 nm, preferably of at least 30 nm, in particular of at least 60 nm, within the VUV wavelength region.

In one embodiment, the base material for reflection of radiation in the UV/VIS wavelength region has a reflectivity at at least one wavelength in the UV/VIS wavelength region of more than 50%, preferably of more than 70%, more preferably of more than 80%, in particular of more than 90%. In the context of this application, the UV/VIS wavelength region means a wavelength range between 200 nm and 830 nm. It has been found to be advantageous when the optical element not only reflects radiation in the VUV wavelength region but also has high reflectivity in regions of the UV/VIS wavelength region, i.e. in the visible wavelength region and/or UV region, for example in order to adjust the reflecting optical element with light in the visible spectral region. The high reflectivity of the optical element in the VIS wavelength region and/or in the (near-)UV wavelength region between 200 nm and 360 nm is largely generated by the base material, meaning that the dielectric multilayer coating is not required for this purpose and makes little or no contribution to the reflectivity of the optical element in the UV/VIS wavelength region. The surface is affected by radiation in the UV/VIS wavelength region; in other words, the dielectric multilayer coating and any further layers of a coating applied to the surface transmit the radiation in the UV/VIS wavelength region, such that it reaches the surface in order to be reflected there.

In one development of the invention, the wavelength in the UV/VIS wavelength region at which the base material has reflectivity of more than 50%, preferably of more than 70%, more preferably of more than 80%, in particular of more than 90%, is 650 nm or higher, preferably 550 nm or higher, more preferably 360 nm or higher, in particular 260 nm or higher. In this way, adjustment of the optical element is simplified, which is performed with the aid of radiation in the UV/VIS wavelength region.

The reflectivity of a metallic base material depends upon factors including the plasma frequency or the photon energy at the plasma frequency of the electron gas of the metallic material. It is advantageous when the plasma frequency or the photon energy of the metallic material is about 1.9 eV - corresponding to a wavelength of 650 nm - or more, or about 2.25 eV - corresponding to a wavelength of 550 nm - or more.

In a further embodiment, the dielectric multilayer coating comprises at least two layers of different materials, preferably fluoridic or oxidic materials, where the dielectric multilayer coating preferably consists of layers of fluoridic materials. The two or more materials of the dielectric multilayer coating should have sufficient transmission or as low as possible absorption in the VUV wavelength region. The two or more materials should additionally have sufficient contrast or difference in refractive index in order to generate maximum reflectivity for radiation in the VUV wavelength region via interference. The production or design of dielectric multilayer coatings for generation of high reflectivity in the VUV wavelength region is known in principle and is therefore not described in detail here. For generation of high reflectivity in the VUV wavelength region, it is advantageous when the dielectric multilayer coating has exclusively fluoride layers and no oxidic layers, since oxidic layers generally have greater absorption for VUV radiation than fluoride layers.

In one development, the fluoridic materials are selected from the group comprising: MgF₂, AlF₃, LaF₃, GdF₃, LiF, YF₃, SrF₂, BaF₂, ErF₃, PrF₃, NdF₃, CaF₂, NaF, chiolite (Na₅Al₃F₁₄), cryolite (Na₂NaAlF₆) and mixtures thereof. These materials have comparatively low absorption in the VUV wavelength region and can be easily separated. It has been found to be advantageous when the first layer of the dielectric multilayer coating, i.e. the layer of the dielectric multilayer coating closest to the surface with the base material, is formed from AlF₃.

In a further development, the oxidic materials are selected from the group comprising: Al₂Os, SiO₂ and mixtures thereof. These oxidic materials have comparatively low absorption in the VUV wavelength region.

It is favourable when the dielectric coating, generally a broadband-reflecting multilayer coating, in particular the material at the interface to the environment, is designed such that high-energy photons (short wavelengths) are reflected in particular close to the interface of the multilayer coating with the environment. In this way, the surface is exposed solely to less high-energy photons, which increases the lifetime of the optical element.

In a further embodiment, the base material of the surface forms a stable fluorine compound with fluorine, preferably a stable metal fluoride, wherein preferably a passivating fluoride layer, in particular a passivating metal fluoride layer, is formed at the surface. For the purposes of this application, a stable fluorine compound, in particular in the form of a metal fluoride, means a fluorine compound which is in the solid state at atmospheric pressure and a temperature of 25°C, preferably of 150°C, in particular of 250°C. An indicator as to whether this criterion is met may be the melting temperature of the fluorine compound or of the metal fluoride, where one third of the melting temperature should be greater than 25°C, preferably greater than 150°C, in particular greater than 250°C.

The passivating fluoride layer can form in the course of operation of the optical element or, as the case may be, even in the course of production thereof, for example, when (post-)fluorination takes place here. In general, it is advantageous to operate fluoridic optics that are exposed to radiation in the VUV wavelength region in a fluorine-containing atmosphere or in a fluorine-containing environment, since it is possible in this way to counteract the loss of fluorine in the solid-state body caused by the action of the radiation in the VUV wavelength region. As shown further up, in the optical element described here, the surface of aluminium can be replaced by a surface of a fluorine-stable base material, for example in the form of a metal, which results in a significant increase in lifetime in the case of an optical element which is operated in a fluorine-containing atmosphere or environment.

As described further up, in a fluorine-containing environment, fluorine gets to the surface in spite of the dielectric multilayer coating. If a stable fluorine compound is formed, a thin passivating fluorine compound is formed on the surface. It is advantageous when the fluorine compound of the base material has polar-covalent bond character (i.e. a small band gap) and does not have strongly ionic bond character.

In a further embodiment, a difference between the electronegativity of fluorine and the electronegativity of the base material is 2.2 or less. The electronegativity value is determined according to Pauling. The electronegativity contrast ΔEN, i.e. the difference between the electronegativity of anion and cation, determines the binding character. A value of ΔEN = 1.7 is considered to be the demarcation line between polar-covalent bonds (with ΔEN ≤ 1.7) and ionically bonded systems or bonds (with ΔEN > 1.7). The electronegativity contrast of 2.2 or less has the effect that the fluorine compound formed in the reaction with fluorine present in the environment, for example in the form of a metal fluoride, has more polar-covalent than ionic binding character, which is favourable for formation of the passivation layer.

In a further embodiment, the base material forms a fluoride with fluorine that has a melting temperature of more than 800°C, preferably of more than 900°C, more preferably of more than 1000°C, in particular more than 1200°C. Especially if the optical element is operated in a fluorine-containing atmosphere, it is favourable for the lifetime of the optical element when the base material forms a non-volatile fluoride with fluorine, in particular a non-volatile metal fluoride. Metal fluorides with a high melting temperature are typically non-volatile (see above). If a metallic base material, for example, forms several fluorides with fluorine, as is the case for example with copper, which forms CuF and CuF₂, the melting temperature refers to that fluoride which has the lowest melting temperature.

In a further variant, the base material has a melting temperature of more than 700°C, preferably more than 800°C, more preferably more than 1000°C. If the base material has a high melting temperature, the dielectric multilayer coating can be deposited at elevated temperature and hence with high density.

The base material should also be readily processible and, in particular, be polishable to high optical quality.

The metallic base material is preferably selected from the group comprising: Cu, Ni, Co, Fe, Hf, Y, Sc, Cd, Zn, lanthanoids and mixtures thereof. These metallic (base) materials each form a metal fluoride having a melting temperature of more than 800°C and hence meet the requirement that no volatile metal fluoride is formed on the metallic surface in a fluorine-containing environment. Under the secondary condition that the metallic base material itself should have a high melting temperature, the following metallic materials remain from the above list: Cu, Ni, Co, Fe, Hf, Y, Sc and possibly lanthanoids. If it is additionally taken into account that the binding character of the metal fluoride should be more polar-covalent than strongly ionic, i.e. the binding character should be small, the following metallic base materials remain from the above list: Cu, Co, Fe, Ni.

It is also possible that the metallic base material is selected from the group comprising: Ru, Cr, Ta, Rh, metals of main groups I and II, i.e. Li, Na, K, Rb, Cs, Be, Mg, Ca, Sr, Ba, and mixtures thereof. These materials are less successful in fulfilling the requirement for fluorine stability formulated further up, but can be used in an optical element in which sufficient stability is achieved in combination with the dielectric layers applied to the base material.

In a further embodiment, the base material is selected from the group comprising: TiO₂, TiN, SiC, VC, Si. These materials are further possible base materials that are particularly attractive in terms of fluorine stability.

In a further embodiment, the surface is formed on a substrate composed of the base material. In this case, the substrate itself forms the base reflector with the surface polished to a high surface quality. In this case, the bulk substrate may have one or more cavities through which a cooling medium can flow in order to reduce the thermal load on the optical element. The substrate may be formed from copper, for example, which has high thermal conductivity and is therefore of good suitability for the removal of heat from the optical element.

In an alternative embodiment, the surface is formed on a layer of the base material that is applied to a substrate. In this case, the base material is applied to the substrate in a coating process. The substrate itself may be formed from the base material, e.g. a metallic material, but this is not absolutely necessary, i.e. the substrate may also be formed from glass, a ceramic, etc.

In a further embodiment, at least one functional layer is disposed between the layer of the base material and the substrate. The functional layer may, for example, be a polishing layer, an adhesive layer or an adhesion promoter layer, a protective layer, a diffusion barrier layer or one or more layers or layer stacks for adjustment of layer stress between the base material and the substrate.

In a further embodiment, at least one functional layer is disposed between the surface and the dielectric multilayer coating. The functional layer may be a smoothing layer or a polishing layer, an adhesion promoter layer, a diffusion barrier layer, a protective layer, etc. In addition to the layers described further up, the dielectric multilayer coating may also have further functional layers which may, for example, be the types of functional layers mentioned further up.

A further aspect of the invention relates to an optical assembly for the VUV wavelength region, in particular a VUV lithography system or a wafer inspection system comprising: at least one optical element designed as described above, wherein the optical element is preferably exposed to a fluorine-containing environment in the operation of the optical assembly. The optical assembly may be a (VUV) lithography system in the form of a VUV lithography assembly, a wafer or mask inspection system, a laser system, etc.

As described further up, it is favourable when the optical element in the optical assembly is operated in a fluorine-containing environment or in a fluorine-containing atmosphere in order to counteract loss of fluorine in the generally fluoridic layers of the dielectric multilayer coating. In this case in particular, it is favourable when the base material is fluorine-stable at the surface.

It is also possible in principle that the optical element described further up is designed firstly for reflection of wavelengths outside the VUV wavelength region and is coated in a coating system. Subsequently, the optical performance of such an optical element in the VUV wavelength region can be increased by post-fluorination. For example, the optical element can be irradiated for this purpose with UV/VUV radiation and/or heated in the presence of a fluorinating active. If the optical element is produced in this way, it is likewise necessary or favourable when the base material of the surface is fluorine-stable even if the optical element in the optical assembly is not operated in a fluorine-containing environment.

In order to increase the lifetime of the optical element on irradiation with radiation in the VUV wavelength region, it may be advantageous when crystal defects are bleached, i.e. healed, in the course of operation of the optical element. For this purpose, the optical element may be irradiated in operation in the optical assembly with UV/VIS radiation in a suitable wavelength range, as described, for example, in WO2022/214376 A1, which is incorporated into this application by reference in its entirety.

Further features and advantages of the invention will be apparent from the description of working examples of the invention that follows, with reference to the figures of the drawing, which show details essential to the invention, and from the claims. The individual features can each be implemented individually or together in any combination in a variant of the invention.

### Drawing

Working examples are shown in the schematic drawing and are elucidated in the description that follows. The figures show:
- Fig. 1a: a schematic diagram of an optical element having a substrate of a metallic material for reflection of radiation in the UV/VIS wavelength region and having a dielectric multilayer coating for reflection of radiation in the VUV wavelength region,
- Fig. 1b: a schematic diagram of an optical element analogous to Fig. 1a in which a metallic layer is applied to the substrate for reflection of radiation in the UV/VIS wavelength region,
- Fig. 2: a schematic diagram of the reflectivity of the optical element of Fig. 1a,b as a function of wavelength,
- Fig. 3a-c: schematic diagrams of the reflectivity of ruthenium, the reflectivity of a dielectric multilayer coating and the reflectivity of a combination of ruthenium and the dielectric multilayer coating,
- Fig. 4: a schematic diagram of an optical assembly for the VUV wavelength region in the form of a VUV lithography apparatus, and
- Fig. 5: a schematic diagram of an optical assembly for the VUV wavelength region in the form of a wafer inspection system.

In the description of the drawings that follows, identical reference symbols are used for identical or functionally identical components.

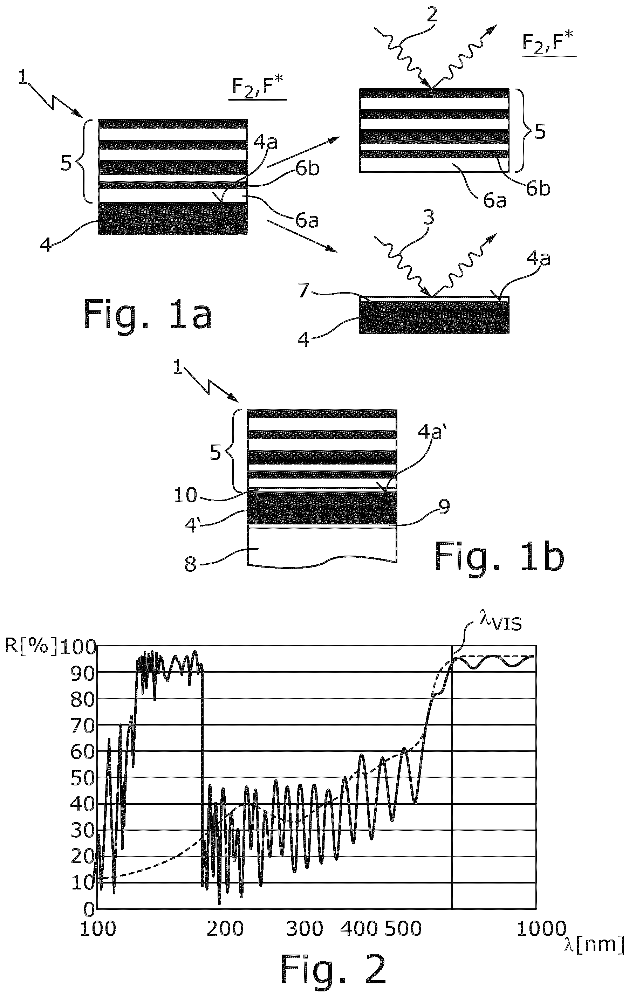

Fig. 1a shows an optical element 1 designed for the reflection of radiation 2 in the VUV wavelength region and for reflection of radiation 3 in the UV/VIS wavelength region. The optical element 1 has a metallic substrate 4 having a metallic surface 4a to which a dielectric multilayer coating 5 is applied. As indicated in Fig. 1a on the right, the dielectric multilayer coating 5 serves to reflect radiation 2 in the VUV wavelength region, while the metallic substrate 4, more specifically the metallic surface 4a of the metallic substrate 4, serves to reflect radiation 3 in the UV/VIS wavelength region.

The substrate 4 and hence also the surface 4a is formed from a metallic base material having a reflectivity of 60% or less in the VUV wavelength region, typically of 50% or less, i.e. the surface 4a of the substrate 4 makes only a minor contribution to the reflectivity of the optical element 1 in the VUV wavelength region. The metallic material of the substrate 4, which is copper in the example shown, has a reflectivity of more than 70%, more specifically of more than 90%, at a wavelength λ_{VIS} in the UV/VIS wavelength region of 650 nm, as apparent in Fig. 2 from a dashed line that corresponds to the reflectivity R of the metallic material as a function of wavelength λ. As can likewise be seen in Fig. 2, the reflectivity R of the metallic material of substrate 4 is also more than 90% at wavelengths in the UV/VIS wavelength region of greater than 650 nm. This makes it possible to adjust the optical element 1 with radiation 3 in the UV/VIS wavelength region.

Fig. 2 shows the reflectivity R of the optical element 1 with a solid line or curve, which is the result of the combination of the metallic base material and the dielectric multilayer coating 5. As can be seen from the solid curve, the optical element 1 for radiation 2 in the VUV wavelength region has a high reflectivity R of more than 70% in a wavelength range having a width of about 60 nm and much more than 80% in a wavelength range having a width of about 30 nm. The optical element 1 is therefore designed for broadband reflection of radiation 2 in the VUV wavelength region.

In the example shown in Fig. 1a, the dielectric multilayer coating 5 consists of a multitude of alternating first and second layers 6a, 6b of fluoridic materials, where the fluoridic material of the first layers 6a differs from the fluoridic material of the second layers 6b. The two fluoridic materials have a comparatively large difference in refractive index and sufficient transmission both in the VUV wavelength region and in the UV/VIS wavelength region. The fluoridic materials of the dielectric multilayer coating 5 may, for example, be selected from the group comprising: MgF₂, AlF₃, LaF₃, GdF₃, LiF, YF₃, SrF₂, BaF₂, ErF₃, PrF₃, NdF₃, CaF₂, NaF, chiolite, cryolite, but may also be other fluoridic materials. The thicknesses of the layers 6a, 6b of the dielectric multilayer coating 5 and the fluoridic materials are chosen according to known optical design principles so as to establish the desired high reflectivity R of the optical element 1 in the VUV wavelength region. Alternatively or additionally to the fluoridic materials, the dielectric multilayer coating 5 may also include oxidic materials, for example Al₂O₃ or SiO₂.

If the optical element 1 is operated in an environment containing molecular fluorine F₂ or active fluorine species, for example in the form of fluorine radicals F*, among other cases, it is favourable when the metallic material of the surface 4a or substrate 4 forms a stable metal fluoride, since fluorine can penetrate through the reflective dielectric multilayer coating 5 and bring about degradation of the metallic surface 4a. It is therefore favourable when the metallic material of the surface 4a is fluorine-stable, i.e. when it forms a stable metal fluoride, which leads to the formation of a thin passivating metal fluoride layer 7 on the metallic surface 4a, as shown in Fig. 1a on the right-hand side. If the metallic material is not fluorine-stable at the surface 4a, by contrast, a volatile metal fluoride can be formed on exposure to the radiation 2 in the VUV wavelength region in the environment containing fluorine F₂, F*, which can promote layer delamination for example.

For fluorine stability of the metallic material, it is first necessary that the metallic material does not form a volatile metal fluoride with fluorine. This is generally the case when the metallic material forms a metal fluoride that has a high melting temperature of more than 800°C, more than 900°C, more than 1000°C, or more than 1200°C.

Metallic materials that meet the above condition with regard to the melting temperature of the metal fluoride are listed in Table 1 below; the values in Table 1 have been taken from "https://www.webelement.com" or "https://www.wikipedia.org":

**Table 1**

| **Metal** | **Metal fluoride** | **Melting temperature / °C** | | **Electronegativity (Pauling)** | | **ΔEN (Pauling)** | **Bond character** |
|---|---|---|---|---|---|---|---|
| **(= Me)** | **(= MeF)** | **Me** | **MeF** | **Me** | **F** | **= EN(F)-EN(Me)** | |
| Cu | CuF | 2561.85 | 908 | 1.9 | 3.98 | 2.08 | 0.38 |
| | CuF₂ | 2561.85 | 836 | 1.9 | 3.98 | 2.08 | 0.38 |
| Ni | NiF₂ | 1454.85 | 1450 | 1.91 | 3.98 | 2.07 | 0.37 |
| Zn | ZnF₂ | 419.53 | 872 | 1.65 | 3.98 | 2.33 | 0.63 |
| Fe | FeF₃ | 1537.85 | 1030 | 1.83 | 3.98 | 2.15 | 0.45 |
| Co | CoF₂ | 1494.85 | 1200 | 1.88 | 3.98 | 2.1 | 0.4 |
| Sc | ScF₃ | 1540.85 | 1553 | 1.36 | 3.98 | 2.62 | 0.92 |
| Y | YF₃ | 1525.85 | 1150 | 1.22 | 3.98 | 2.76 | 1.06 |
| Cd | CdF₂ | 321.07 | 1078 | 1.69 | 3.98 | 2.29 | 0.59 |
| Hf | HfF₄ | 2232.85 | 1140 | 1.3 | 3.98 | 2.68 | 0.98 |
| Al | AlF₃ | 660.32 | 1260 | 1.61 | 3.98 | 2.37 | 0.67 |
| La | LaF₃ | 919.85 | 1493 | 1.1 | 3.98 | 2.88 | 1.18 |
| Ce | CeF₃ | 764.85 | 1460 | 1.12 | 3.98 | 2.86 | 1.16 |
| Pr | PrF₃ | 934.85 | 1399 | 1.13 | 3.98 | 2.85 | 1.15 |
| Nd | NdF₃ | 1023.85 | 1377 | 1.14 | 3.98 | 2.84 | 1.14 |
| Pm | PmF₃ | 1041.85 | 1338 | | 3.98 | | |
| Sm | SmF₃ | 1071.85 | 1306 | 1.17 | 3.98 | 2.81 | 1.11 |
| Eu | EuF₃ | 825.85 | 1390 | | 3.98 | | |
| Gd | GdF₃ | 1311.85 | 1231 | 1.2 | 3.98 | 2.78 | 1.08 |
| Tb | TbF₃ | 1355.85 | 1172 | | 3.98 | | |
| Dy | DyF₃ | 1406.85 | 1360 | 1.22 | 3.98 | 2.76 | 1.06 |
| Ho | HoF₃ | 1460.85 | 1143 | 1.23 | 3.98 | 2.75 | 1.05 |
| Er | ErF₃ | 1528.85 | 1146 | 1.24 | 3.98 | 2.74 | 1.04 |
| Tm | TmF₃ | 1544.85 | 1158 | 1.25 | 3.98 | 2.73 | 1.03 |
| Yb | YbF₃ | 823.85 | 1157 | | 3.98 | | |
| Lu | LuF₃ | 1651.85 | 1182 | 1.27 | 3.98 | 2.71 | 1.01 |

In order to be able to deposit the dielectric multilayer coating 5 with maximum density, it is additionally advantageous when the metallic material can be heated in the course of deposition. The metallic material therefore preferably has a melting temperature of more than 700°C, more than 800°C or more than 1000°C. Of the metallic materials in Table 1, this condition is met by the following metals: Cu, Ni, Co, Fe, Hf, Y, Sc, and the lanthanoids, i.e. La, Ce, Pr, Nd, Pm, Sm, Eu, Gd, Tb, Dy, Ho, Er, Tm, Yb, Lu.

In order to achieve the effect that a passivating metal fluoride layer 7 forms on the metallic surface 4a as described above, it has been found to be favourable when the bond character of the metal fluoride is polar-covalent rather than ionic, i.e. when the difference ΔEN(Pauling) between the electronegativity EN(F) of fluorine and the electronegativity EN(Me) of the metallic material is 2.2 or less (cf. Table 1). The bond character in the right-hand column is defined as the difference ΔEN(Pauling) - 1.7, since a value ΔEN(Pauling) of 1.7 corresponds to the demarcation line between polar-covalent and ionically bonded systems. Of the metallic materials listed in Table 1, this additional condition is met by Cu, Co, Fe, Ni.

In the example shown in Fig. 1a, copper was selected as the material for the substrate 4. Copper has high thermal conductivity and therefore enables removal of heat from the optical element 1 in a particularly effective manner. It is possible that the substrate 4 composed of copper has one or more cavities through which a temperature control fluid, e.g. water, can flow in order to remove the heat particularly efficiently.

The optical element 1 shown in **Fig. 1b** differs from the optical element 1 shown in Fig. 1a in that the metallic surface 4a' is formed on a thin metallic layer 4' that is applied to a substrate 8. In the example shown, the metallic layer 4' has a thickness in the order of magnitude of typically about 50 - 100 nm. The substrate 8 is not formed from a metallic material and, in the example shown, consists of quartz glass.

As can likewise be seen in Fig. 1b, a functional layer 9 is disposed between the metallic layer 4' and the substrate 8. The functional layer 9 in the example shown is a polishing layer, but it may also be an adhesive layer or an adhesion promoter layer or one or more layers or a layer stack for adjusting the layer stress between the metallic material of the metallic layer 4' and the material of the substrate 8, or a diffusion barrier layer or a protective layer.

In the optical element 1 of Fig. 1b, a further functional layer 10 disposed between the metallic surface 4a' and the dielectric multilayer coating 5 is a smoothing layer. However, the functional layer 10 may also fulfil another function. It will be apparent that, in the example shown in Fig. 1a, a further functional layer may be disposed between the dielectric multilayer coating 5 and the metallic surface 4a.

In addition to the metallic base materials described further up, it is also possible to use other metallic base materials for the surface 4, 4' that are less successful in meeting the above-formulated requirement for fluorine stability, but nevertheless achieve sufficient fluorine stability in combination with the dielectric layers 6a, 6b applied to the base material. These metallic materials may in particular be Ru, Cr, Ta or Rh.

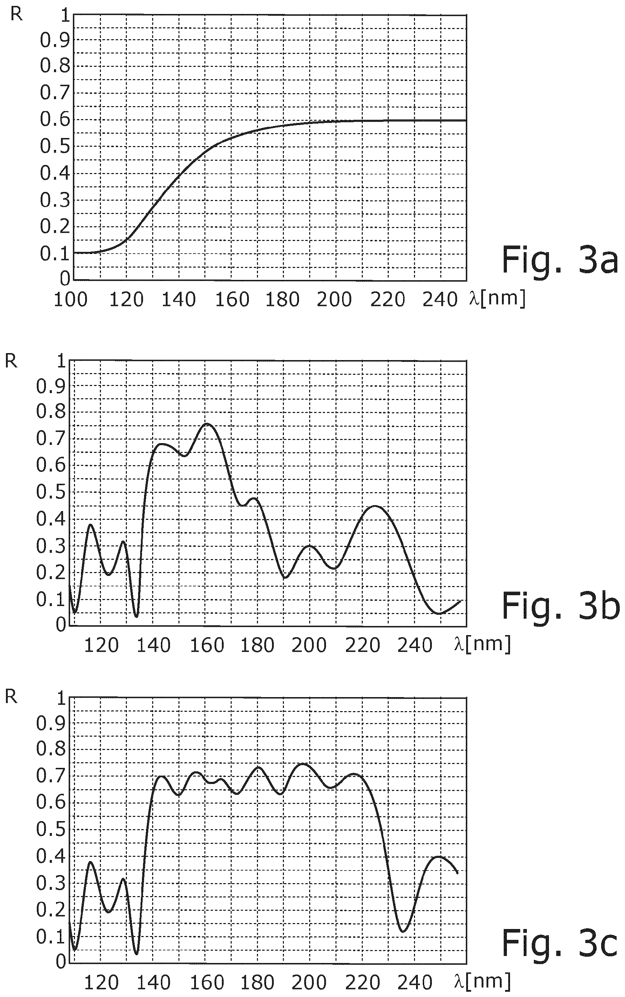

**Fig. 3a** shows the reflectivity R of ruthenium as metallic material of the surface 4 of Fig. 1a or the surface 4' of Fig. 1b as a function of wavelength. As can be seen in Fig. 3a, ruthenium in the VUV wavelength region has a reflectivity R (for vertical incidence) of more than 50% and of not more than 60% at wavelengths of more than 115 nm. **Fig. 3b** shows the reflectivity R of a dielectric multilayer coating 5 formed from three layers consisting of Al₂O₃, AlF₃ and LaF₃ (also for vertical incidence). The reflective multilayer coating 5 was optimized for a high reflectivity R in the wavelength range between 140 nm and 170 nm in order to generate high broadband reflectivity R together with the reflectivity R of the metallic surface 4 or 4' as shown in Fig. 3a, which is more than 60% or close to 70% in a wavelength range between about 140 nm and 220 nm, as can be seen in **Fig. 3c**. Comparison between Fig. 3b and Fig. 3c shows that the metallic surface 4 or 4' contributes significantly to the reflection of the optical element 1.

In the examples described further up, the surface 4, 4' is formed from a metallic base material having a reflectivity of 60% or less in the VUV wavelength region, or of 50% or less. However, it is also possible that the surface 4, 4' is formed from a non-metallic base material that has this property. For example, the base material may be selected from the group comprising: TiO₂, TiN, SiC, VC, Si and mixtures thereof. These base materials may also be fluorine-stable or have sufficient fluorine stability in combination with the dielectric layers applied to the base material.

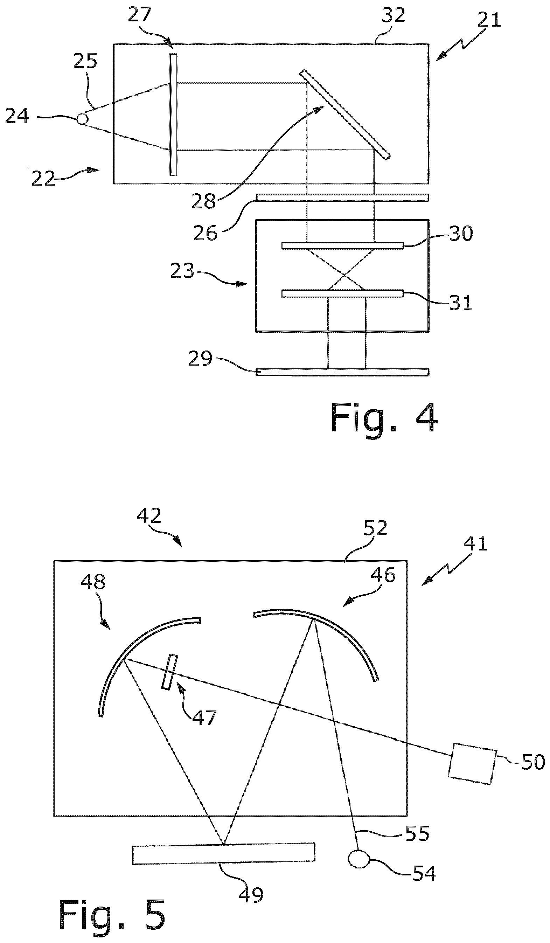

**Fig. 4** shows an optical assembly for the VUV wavelength region in the form of a VUV lithography apparatus 21. The VUV lithography apparatus 21 comprises two optical systems, namely an illumination system 22 and a projection system 23. The VUV lithography apparatus 21 additionally has a radiation source 24, which may be an excimer laser for example.

The radiation 25 emitted by the radiation source 24 is conditioned with the aid of the illumination system 22 such that a mask 26, also called a reticle, is illuminated thereby. In the example shown, the illumination system 22 has a housing 32, in which there are disposed both transmissive and reflective optical elements. In a representative manner, the illustration shows a transmissive optical element 27, which focuses the radiation 25, and a reflective optical element 28, which deflects the radiation.

The mask 26 has, on its surface, a structure which is transferred to an optical element 29 to be exposed, for example a wafer, with the aid of the projection system 23 for the purpose of producing semiconductor components. In the example shown, the mask 26 is designed as transmissive optical element. In alternative embodiments, the mask 26 may also be designed as reflective optical element.

The projection system 22 comprises at least one transmissive optical element in the example illustrated. The example shown illustrates, in a representative manner, two transmissive optical elements 30, 31, which serve, for example, to reduce the structures on the mask 26 to the size desired for the exposure of the wafer 29.

Both in the illumination system 22 and in the projection system 23, a wide variety of transmissive, reflective or other optical elements can be combined with one another as desired, including in a more complex manner. Optical assemblies without transmissive optical elements can also be used for VUV lithography.

**Fig. 5** shows an optical assembly for the VUV wavelength region in the form of a wafer inspection system 41, but this may also be a mask inspection system. The wafer inspection system 41 has an optical system 42 with a radiation source 54, from which radiation 55 is directed onto a wafer 49 by means of the optical system 42. For this purpose, the radiation 55 is reflected onto the wafer 49 by a concave mirror 46. In the case of a mask inspection system, it would be possible to replace the wafer 49 with a mask to be examined. The radiation reflected, diffracted and/or refracted by the wafer 49 is directed onto a detector 50 for further evaluation by a further concave mirror 48, which is likewise associated with the optical system 42, via a transmissive optical element 47. The wafer inspection system 41 additionally has a housing 52, in which there are disposed the two mirrors 46, 48 and the transmissive optical element 47. The radiation source 54 may, for example, be exactly one radiation source or a combination of a plurality of individual radiation sources in order to provide a substantially continuous radiation spectrum. In modifications, it is also possible to use one or more narrowband radiation sources 54.

At least the optical element 28 of the VUV lithography apparatus 21 shown in Fig. 4 and at least one of the optical elements 46, 48 of the wafer inspection system 41 shown in Fig. 5 are designed here like the optical element 1 of Fig. 1a,b. The VUV lithography system 21 and the wafer inspection system 41 may in particular be designed to operate the optical element 28, 46, 48 in a fluorine-containing environment or a fluorine-containing atmosphere, or the optical element 28, 46, 48 may be disposed in a fluorine-containing environment.

## Claims

1. Optical element (1) for reflecting radiation (2, 25, 55) in the VUV wavelength region, comprising:
a surface (4a, 4a'), and
a dielectric multilayer coating (5) applied to the surface (4a, 4a'),
**characterized in that**
the dielectric multilayer coating (5) is designed for reflection, in particular for broadband reflection, of radiation (2, 25, 55) in the VUV wavelength region, and
the surface (4a, 4a') is formed from a preferably metallic base material having a reflectivity of 60% or less in the VUV wavelength region, in particular of 50% or less.

2. Optical element according to Claim 1, in which the base material for reflection of radiation (3) in the UV/VIS wavelength region has a reflectivity at at least one wavelength (λ_{VIS}) in the UV/VIS wavelength region of more than 50%, preferably of more than 70%, more preferably of more than 80%, in particular of more than 90%.

3. Optical element according to Claim 2, in which the wavelength (λ_{VIS}) in the UV/VIS wavelength region at which the base material has reflectivity of more than 50%, preferably of more than 70%, more preferably of more than 80%, in particular of more than 90%, is 650 nm or higher, preferably 550 nm or higher, more preferably 360 nm or higher, in particular 260 nm or higher.

4. Optical element according to any of the preceding claims, in which the dielectric multilayer coating (5) comprises at least two layers (6a, 6b) of different materials, preferably fluoridic or oxidic materials, where the dielectric multilayer coating (5) preferably consists of layers (6a, 6b) of fluoridic materials.

5. Optical element according to Claim 4, in which the fluoridic materials are selected from the group comprising: MgF₂, AlF₃, LaF₃, GdF₃, LiF, YF₃, SrF₂, BaF₂, ErF₃, PrF₃, NdF₃, CaF₂, NaF, chiolite, cryolite and mixtures thereof.

6. Optical element according to Claim 4 or 5, in which the oxidic materials are selected from the group comprising: Al₂O₃, SiO₂ and mixtures thereof.

7. Optical element according to any of the preceding claims, in which the base material of the surface (4a, 4a') forms a stable fluorine compound with fluorine, preferably a stable metal fluoride, wherein preferably a passivating fluoride layer, in particular a passivating metal fluoride layer (7), is formed at the surface (4a, 4a').

8. Optical element according to any of the preceding claims, in which a difference between the electronegativity of fluorine and the electronegativity of the base material is 2.2 or less.

9. Optical element according to any of the preceding claims, in which the base material forms a fluoride with fluorine that has a melting temperature of more than 800°C, preferably of more than 900°C, more preferably of more than 1000°C, in particular more than 1200°C.

10. Optical element according to any of the preceding claims, in which the base material has a melting temperature of more than 700°C, preferably more than 800°C, more preferably more than 1000°C.

11. Optical element according to any of the preceding claims, in which the metallic base material is selected from the group comprising: Cu, Ni, Co, Fe, Hf, Y, Sc, Cd, Zn, lanthanoids and mixtures thereof.

12. Optical element according to any of Claims 1 to 10, in which the base material is selected from the group comprising: TiO₂, TiN, SiC, VC, Si and mixtures thereof.

13. Optical element according to any of the preceding claims, in which the surface (4a) is formed on a substrate (4) composed of the base material.

14. Optical element according to any of Claims 1 to 12, in which the surface (4a') is formed on a layer (4') of the base material that is applied to a substrate (8).

15. Optical element according to Claim 14, in which at least one functional layer (9) is disposed between the layer (4') of the base material and the substrate (8).

16. Optical element according to any of the preceding claims, in which at least one functional layer (10) is disposed between the surface (4a, 4a') and the dielectric multilayer coating (5).

17. Optical assembly for the VUV wavelength region, in particular VUV lithography system (21) or wafer inspection system (41), comprising: at least one optical element (1, 27, 28, 30, 31, 46, 47, 48) according to any of the preceding claims, which is preferably exposed to a fluorine-containing environment in operation of the optical assembly.
